# EUROPÄISCHE PATENTANMELDUNG

(11) **EP 1 624 572 A1**
(43) Veröffentlichungstag der Anmeldung: **08.02.2006**
(21) Anmeldenummer: 05016720.4
(22) Anmeldetag: 02.08.2005
(51) Int. Cl.: H03K 17/10

(54) **Integrierte Schaltung, die eine vorgegebene Spannungsfestigkeit besitzt**

(30) Priorität: 06.08.2004 DE 102004039620
(71) Anmelder: ATMEL Germany GmbH, 74072 Heilbronn (DE)
(72) Erfinder: Hehn, Lars, 74080 Heilbronn (DE); Gruber, Berthold, 74906 Bad Rappenau (DE)

(57) **Zusammenfassung**

Vorgestellt wird eine Integrierte Schaltung (64; 66) mit einem ersten Anschluss (50), einem zweiten Anschluss (52), einem Substrat und einem Steueranschluss (86), wobei der Steueranschluss (86) eine Leitfähigkeit der Integrierten Schaltung (64; 66) zwischen dem ersten Anschluss (50) und dem zweiten Anschluss (52) steuert. Die Integrierte Schaltung (64; 66) zeichnet sich aus durch einen ersten Transistor (66) und n weitere Transistoren (68, 70, 72) mit in Reihe zwischen den ersten Anschluss (50) und den zweiten Anschluss (52) geschalteten Leitfähigkeitsstrecken, wobei n eine ganze Zahl größer oder gleich 1 ist, n Dioden (74, 76, 78), wobei jede der n Dioden (74, 76, 78) zwischen einem Steueranschluss (80, 82, 84) der n Transistoren (68, 70, 72) und einem Treiber-Versorgungspotential (VSH + Δ) liegt, das dem mit einem additiven Offset (Δ) verknüpften Potential (VSH) am ersten Anschluss (50) entspricht, und wobei der Steueranschluss (86) der Integrierten Schaltung (64) entweder das Treiber-Versorgungspotential (VSH + A) oder das Potential (VSH) am ersten Anschluss (50) an einen Steueranschluss (88) des ersten Transistors (66) übergibt, und einen Spannungsteiler (90), der parallel zu den Leitfähigkeitsstrecken zwischen dem ersten Anschluss (50) und dem zweiten Anschluss (52) liegt und der Steueranschlüsse (88, 80, 82, 84) der Transistoren (66, 68, 70, 72) miteinander und mit dem ersten Anschluss (50) sowie dem zweiten Anschluss (52) verbindet, wobei jeweils zwei Steueranschlüsse der Transistoren (66, 68, 70, 72) über einen zwischen ihnen liegenden Teilabschnitt (92, 94, 96) des Spannungsteilers (90) miteinander verbunden sind.

## Beschreibung

Die Erfindung betrifft eine Integrierte Schaltung mit einem ersten Anschluss, einem zweiten Anschluss, einem Substrat und einem Steueranschluss, wobei der Steueranschluss eine Leitfähigkeit der Integrierten Schaltung zwischen dem ersten und dem zweiten Anschluss steuert.

Eine solche Integrierte Schaltung entspricht einem Transistor und ist daher bekannt. Bei einer Realisierung der Integrierten Schaltung durch einen einzelnen Feldeffekttransistor wird der erste Anschluss durch den Source-Anschluss, der zweite Anschluss durch den Drain-Anschluss und der Steueranschluss durch den Gate-Anschluss des Feldeffekttransistors definiert. Bei einer Realisierung als Bipolartransistor wird der erste Anschluss z. B. durch den Emitter, der zweite Anschluss durch den Kollektor und der Steueranschluss durch die Basis des Bipolartransistors realisiert.

Je nach Anwendungsfall muss eine solche Integrierte Schaltung, die einen ersten Anschluss, einen zweiten Anschluss, ein Substrat und einen Steueranschluss aufweist, bestimmte Anforderungen für die Spannungsfestigkeit zwischen dem ersten Anschluss und dem zweiten Anschluss auf der einen Seite und dem ersten Anschluss oder dem zweiten Anschluss und dem Substrat auf der anderen Seite erfüllen. Dabei können die innerhalb einer Schaltung geforderten Spannungsfestigkeiten verschieden sein. Bei einem Anwendungsbeispiel einer Schaltung zur Steuerung einer Brückenschaltung aus Leistungstransistoren, wie sie weiter unten noch detaillierter vorgestellt wird, ergeben sich Potentialdifferenzen zwischen dem ersten Anschluss und dem Substrat, die größenordnungsmäßig zwischen - 10 und + 60 V schwanken können. Zusätzlich ergeben sich zwischen dem ersten Anschluss und dem zweiten Anschluss einer solchen Integrierten Schaltung Spannungen von bis zu 20 V, so dass z. B. am zweiten Anschluss der Integrierten Schaltung eine Potentialdifferenz von 20 V + 60 V = 80 V zum Substrat auftreten kann. Diese Anforderungen an die Spannungsfestigkeit zwischen erstem und zweitem Anschluss auf der einen Seite und dem ersten oder zweiten Anschluss und dem Substrat auf der anderen Seite können im Prinzip mit speziell entworfenen Einzeltransistoren erfüllt werden.

Der Entwurf und die Fertigung eines jeweils für spezielle Anforderungen individuell angepassten Einzeltransistors ist jedoch sehr aufwändig. Die Alternative einer Beschränkung der Anwendungsfälle auf solche, die sich durch eine Verwendung vorhandener Einzeltransistoren als Integrierte Schaltungen realisieren lassen, würde die Zahl möglicher Anwendungen unerwünscht einengen.

Vor diesem Hintergrund besteht die Aufgabe der Erfindung in der Angabe einer Integrierten Schaltung, die eine Erfiillung der bei verschiedenen Anwendungsfällen verschiedenen Anforderungen an die Spannungsfestigkeit für eine große Zahl von Anwendungsfällen mit einer kleineren Zahl von vorhandenen Transistortypen mit jeweils unterschiedlichen Eigenschaften ermöglicht.

Diese Aufgabe wird bei einer Integrierten Schaltung der eingangs genannten Art gelöst, die aufweist: Einen ersten Transistor und n weitere Transistoren mit in Reihe zwischen den ersten und den zweiten Anschluss geschalteten Leitfähigkeitsstrecken, wobei n eine ganze Zahl ≥ 1 ist, n Dioden, wobei jede der n Dioden zwischen einem Steueranschluss der n Transistoren und einem Versorgungspotential liegt, das dem mit einem additiven Offset verknüpften Potential am ersten Anschluss entspricht, und wobei der Steueranschluss der Integrierten Schaltung entweder das Versorgungspotential oder das Potential am ersten Anschluss an einen Steueranschluss des ersten Transistors übergibt, und einen Spannungsteiler, der parallel zu den Leitfähigkeitsstrecken zwischen dem ersten Anschluss und dem zweiten Anschluss liegt und der Steueranschlüsse der Transistoren miteinander und mit dem ersten Anschluss sowie dem zweiten Anschluss verbindet, wobei jeweils zwei Steueranschlüsse der Transistoren über einen zwischen ihnen liegenden Teilabschnitt des Spannungsteilers miteinander verbunden sind.

Durch diese Merkmale wird die Aufgabe der Erfindung vollkommen gelöst. Im Einzelnen ergibt sich durch die in Reihe zwischen dem ersten und dem zweiten Anschluss liegenden Leitfähigkeitsstrecken mehrerer Einzeltransistoren eine Spannungsfestigkeit zwischen den genannten Anschlüssen, die der Summe der Spannungsfestigkeiten der verwendeten Einzeltransistoren entspricht. Jeder einzelne der verwendeten Einzeltransistoren muss dann lediglich die geforderte Spannungsfestigkeit zum Substrat besitzen. Die für die gesamte Integrierte Schaltung geforderte Spannungsfestigkeit zwischen dem ersten und zweiten Anschluss lässt sich dann durch die Reihenschaltung mehrerer Leitfähigkeitsstrecken stufenweise beliebig steigern.

Die Dioden sorgen einerseits dafür, dass sich die Steueranschlüsse der Transistoren synchron zueinander in Flussrichtung der Dioden ansteuern lassen. Dadurch werden die Transistoren durch Aktivierung ihrer Leitfähigkeitsstrecken eingeschaltet. Andererseits erlauben die Dioden im ausgeschalteten Zustand der Transistoren die Einstellung verschiedener Gate-Potentiale an den verschiedenen Transistoren ohne wechselseitige Beeinflussung über eine gemeinsame Ansteuerleitung. Dabei werden die Transistoren durch Anlegen des Potentials am ersten Anschluss an den Steueranschluss des ersten Transistors ausgeschaltet und durch Anlegen des Versorgungspotentials an dieser Steueranschluss eingeschaltet.

Im ausgeschalteten Zustand muss dafür gesorgt werden, dass die Spannung über der Leitfähigkeitsstrecke jedes einzelnen Transistors nicht größer als ein zulässiger Maximalwert wird. Dies wird mit Hilfe des Spannungsteilers erreicht, der die Spannung zwischen dem ersten Anschluss und dem zweiten Anschluss der Integrierten Schaltung gleichmäßig auf die n Transistoren verteilt.

Eine Ausgestaltung der Erfindung zeichnet sich dadurch aus, dass der Spannungsteiler eine Diode aufweist, die zwischen dem zweiten Anschluss der Integrierten Schaltung und dem Steueranschluss des Transistors liegt, dessen Leitfähigkeitsstrecke ebenfalls an dem zweiten Anschluss der Integrierten Schaltung liegt.

Durch die richtungsabhängige Sperrwirkung dieser Diode lässt sich am Steueranschluss dieses Transistors eine höhere Spannung einstellen als am zweiten Anschluss der Integrierten Schaltung. Dadurch lässt sich dieser Transistor unabhängig vom Potential am zweiten Anschluss der Integrierten Schaltung einschalten.

Eine weitere bevorzugte Ausgestaltung weist eine Reihenschaltung aus n Zenerdioden auf, von denen jede parallel zu einem der Teilabschnitte des Spannungsteilers liegt, mit denen Steueranschlüsse der Transistoren miteinander verbunden sind.

Im Fall einer Überspannung, die bspw. durch eine elektrostatische Entladung zwischen dem ersten und dem zweiten Anschluss der Integrierten Schaltung auftreten kann, öffnen diese Zenerdioden einen Strompfad, der die Teilabschnitte des Spannungsteilers überbrückt, so dass sich an den Steueranschlüssen der Transistoren gleiche, öffnende Potentiale einstellen.

Bevorzugt ist auch, dass ein Widerstand zwischen dem Steueranschluss der Integrierten Schaltung und dem Steueranschluss des ersten Transistors angeordnet ist. Im Fall einer Überspannung mit geöffneten Zenerdioden sorgt dieser Widerstand für eine Potentialdifferenz zwischen dem Steueranschluss des ersten Transistors und dem Steueranschluss der Integrierten Schaltung. Dadurch wird gewährleistet, dass auch der erste Transistor im Fall einer Überspannung öffnend angesteuert wird. Durch das öffnende Ansteuern der Transistoren wird eine durchgehende Leitfähigkeitsstrecke zwischen dem ersten Anschluss und dem zweiten Anschluss der Integrierten Schaltung bereitgestellt, über die ein Abbau der Überspannung erfolgen kann.

Bevorzugt ist auch, dass die Transistoren als MOS-Feldeffekttransistoren realisiert sind.

Solche MOS-Feldeffekttransistoren lassen sich im Gegensatz zu Bipolar-Transistoren kapazitiv und damit nahezu stromlos steuern, was den Stromverbrauch der Integrierten Schaltung verringert. Bei einer solchen Realisierung dienen die Gate-Anschlüsse der Feldeffekttransistoren als Steueranschlüsse. Die Source-Anschlüsse der Feldeffekttransistoren sind zum ersten Anschluss der Integrierten Schaltung gerichtet und die Drain-Anschlüsse sind zum zweiten Anschluss der Integrierten Schaltung gerichtet. Es versteht sich aber, dass die Integrierte Schaltung im Prinzip auch mit Bipolartransistoren realisiert werden kann.

Bevorzugt ist auch, dass die Integrierte Schaltung in CMOS-Technik realisiert wird.

Im Rahmen der CMOS-Technik können bekanntlich n-Kanal- und p-Kanal-Feldeffekttransistoren im gleichen Substrat erzeugt werden. Da n-Kanal- und p-Kanal-Feldeffekttransistoren entgegengesetzt auf gleiche Ansteuersignale reagieren, lassen sich mit einem Ansteuersignal gleichzeitig Einschaltvorgänge und Ausschaltvorgänge steuern.

Eine weitere bevorzugte Ausgestaltung zeichnet sich durch eine Teilschaltung aus, die ein variables Potential an den ersten Anschluss übergibt.

Diese Teilschaltung kann z. B. der untere Teil einer Halbbrücke sein, der an einem niedrigen Versorgungspotential liegt, während die Integrierte Schaltung zwischen dem ersten Anschluss und einem hohen Versorgungspotential liegt. Je nachdem, ob die Integrierte Schaltung oder die Teilschaltung leitfähig gesteuert wird, ergibt sich am Verbindungspunkt der Teilschaltung zur Integrierten Schaltung und damit am ersten Anschluss entweder das niedrige Versorgungspotential oder aber das höhere Versorgungspotential. Auf diese Weise kann z. B. ein Verbraucher, der an den Verbindungspunkt angeschlossen ist, gesteuert werden.

Eine weitere bevorzugte Ausgestaltung zeichnet sich durch einen ersten Leistungstransistor aus, dessen Leitfähigkeitsstrecke zwischen dem ersten Anschluss und einer Stromquelle liegt und der durch den zweiten Anschluss gesteuert wird.

Die Integrierte Schaltung wird im Rahmen dieser Ausgestaltung zum Ausschalten des genannten Leistungstransistors verwendet. Wenn die Leitfähigkeitsstrecken der Integrierten Schaltung gesperrt sind, kann durch weitere Schaltungsteile ein Potentialunterschied zwischen Gate und Source des Leistungstransistors eingestellt werden. Werden die Leitfähigkeitsstrecken der Integrierten Schaltung dagegen in den leitenden Zustand gesteuert, so ergeben sich gleiche Potentiale an Gate und Source des Leistungstransistors, wodurch dieser in den sperrenden Zustand gesteuert wird.

Bevorzugt ist auch, dass die Schaltung einen weiteren Leistungstransistor aufweist, dessen Leitfähigkeitsstrecke mit der Leitfähigkeitsstrecke des ersten Leitfähigkeitstransistors in Reihe zwischen der Stromquelle und einem Bezugspotential der Schaltung liegt.

Der weitere Leistungstransistor wird bevorzugt im Wechsel mit dem ersten Leistungstransistor leitend oder sperrend gesteuert, so dass sich am Verbindungspunkt der beiden Leistungstransistoren wechselweise das Potential der Stromquelle oder aber das Bezugspotential einstellt. Auf diese Weise kann ein an dem Verbindungspunkt angeschlossener Verbraucher wechselweise mit beiden Potentialen versorgt werden.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert.

Es zeigen:
- Figur 1: eine Halbbrücke als Beispiel eines technischen Umfeldes der Erfindung;
- Figur 2: einen Querschnitt durch einen MOS-Transistor zur Verdeutlichung von Anforderungen an die Spannungsfestigkeit;
- Figur 3: ein erstes Ausführungsbeispiel der Erfindung mit Beispielwerten von Spannungen, die sich im eingeschalteten Zustand der Integrierten Schaltung ergeben; und
- Figur 4: ein weiteres Ausführungsbeispiel der Erfindung mit Beispielwerten von Spannungen, die sich im ausgeschalteten Zustand der Integrierten Schaltung einstellen.

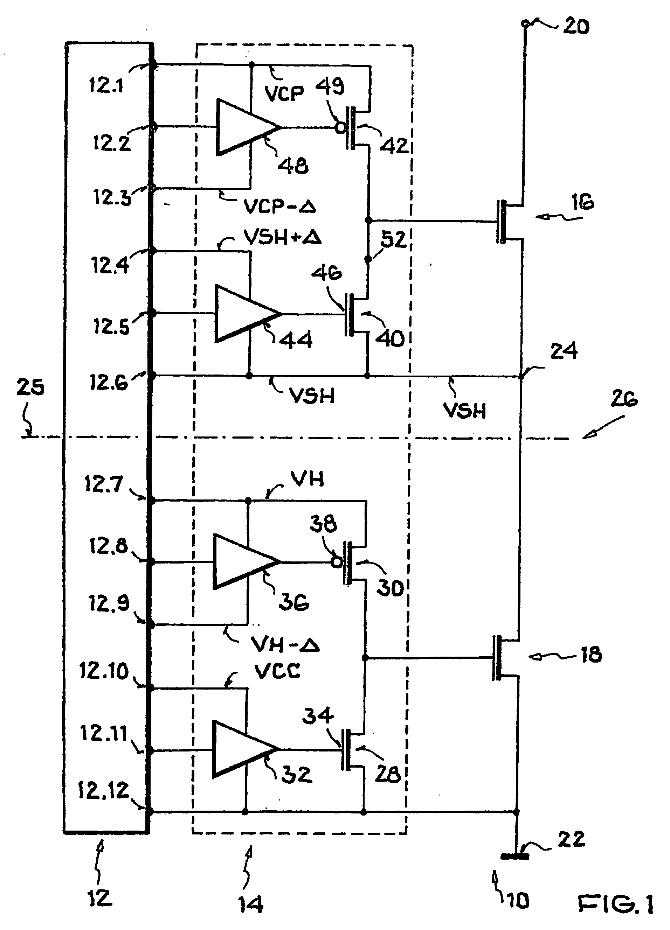

Figur 1 zeigt eine Halbbrücke 10, die von einer Steuerlogik 12 über eine Ansteuerschaltung 14 gesteuert wird. Die Halbbrücke 10 weist einen ersten Leistungstransistor 16 und einen zweiten Leistungstransistor 18 auf, die in Reihe zwischen einen Leistungsversorgungspotentialanschluss 20 und einen Bezugspotentialanschluss 22 geschaltet sind. Über die Ansteuerschaltung 14 schaltet die Steuerlogik 12 entweder den ersten Leistungstransistor 16 oder den zweiten Leistungstransistor 18 ein. Dazu weist die Steuerlogik 12 Ausgänge 12.1 bis 12.12 auf, die Versorgungsspannungen und/oder Steuersignale ausgeben. Bei eingeschaltetem ersten Leistungstransistor 16 wird der zweite Leistungstransistor 18 ausgeschaltet und umgekehrt. An einem ersten Anschluss 24, der zwischen den beiden Leistungstransistoren 16, 18 liegt, stellt sich daher bei eingeschaltetem zweiten Leistungstransistor 18 das Bezugspotential vom Anschluss 22 ein und bei eingeschaltetem ersten Leistungstransistor 16 stellt sich am ersten Anschluss 24 das Leistungs-Versorgungspotential von Anschluss 20 ein.

Der in der Figur 1 unterhalb des ersten Anschlusses 24 und der Linie 25 liegende Teil der Schaltung mit dem zweiten Leistungstransistor 18 und dem zugehörigen Teil der Ansteuerschaltung 14 stellt damit eine Teilschaltung 26 dar, die ein variables Potential an den ersten Anschluss 24 übergibt. Der zweite Leistungstransistor 18 wird von zwei komplementären Feldeffekttransistoren 28 und 30 gesteuert, die in Reihe zwischen dem Bezugspotentialanschluss 22 und einer Versorgungsspannung VH liegen, die vom Ausgang 12.7 der Steuerlogik 12 ausgegeben wird. In der Figur 1 ist der untere Transistor 28 als N-Kanal-Feldeffekttransistor (NMOS-Fet) und der obere Transistor 30 als P-Kanal-Feldeffekttransistor (PMOS-Fet) realisiert. Ein Treiber 32 steuert einen Steueranschluss 34 des NMOS-Fet 28 in Abhängigkeit von Befehlen der Steuerlogik 12, die über den Ausgang 12.11 ausgegeben werden. Der Treiber 32 legt entweder das am Ausgang 12.12 anliegende Bezugspotential oder ein vom Ausgang 12.10 ausgegebenes Potential VCC auf den Steueranschluss 34, wobei VCC gegenüber dem Bezugspotential positiv ist und den NMOS-Fet 28 einschaltet.

Analog wird der PMOS-Fet 30 durch den Treiber 36 gesteuert, der entweder ein ausschaltendes Potential VH vom Ausgang 12.7 oder ein einschaltendes Potential V_H - Δ vom Ausgang 12.9 auf einen Steueranschluss 38 des PMOS-Fet 30 legt. Der Wert von Δ kann z. B. 5 V betragen. Dabei beziehen sich die Potentiale VCC und VH auf das konstante Bezugspotential am Anschluss 22 der Anordnung, das auch dem Substratpotential der Transistoren 28, 30 entspricht. VCC und VH können typischerweise in einer Größenordnung von etwa 10 V liegen, so dass sich keine hohen Anforderungen an die Spannungsfestigkeit der Transistoren 28, 30 ergeben.

Bei den Transistoren 40 und 42, die den ersten Leistungstransistor 16 steuern, ergeben sich dagegen wesentlich höhere Anforderungen an die Spannungsfestigkeit. Bei einer Integration der Schaltung nach Figur 1 auf einem Chip entspricht das Substratpotential dieser Transistoren 40, 42 dem Bezugspotential am Anschluss 22 und ist damit konstant niedrig. Die übrigen Potentiale an Anschlüssen der Transistoren 40, 42 hängen dagegen davon ab, welcher der beiden Leistungstransistoren 16 und 18 eingeschaltet ist. Bei eingeschaltetem zweiten Leistungstransistor 18 und ausgeschaltetem ersten Leistungstransistor 16 stellt sich am ersten Anschluss 24 der Schaltung das Bezugspotential ein. Ist dagegen nur der erste Leistungstransistor 16 eingeschaltet, stellt sich am ersten Anschluss 24 das Leistungs-Versorgungspotential 20 ein. Sämtliche Potentiale, die an Anschlüssen der Transistoren 40, 42 auftreten, basieren auf dem Potential, das sich am ersten Anschluss 24 einstellt. Dadurch werden insbesondere die Potentialunterschiede zum Substratpotential erheblich vergrößert.

Der Treiber 44, der den NMOS-Transistor 40 steuert, legt an den Steueranschluss 46 entweder das ausschaltende Potential VSH des ersten Anschlusses 24 oder ein einschaltendes Potential VSH + Δ, das gegenüber VSH positiv ist. Auch hier kann Δ z. B. einen Wert von 5 V besitzen. VSH liegt auch am Anschluss 12.6, während VSH + Δ vom Ausgang 12.4 und das Treiber-Steuersignal vom Anschluss 12.5 ausgegeben wird.

Analog legt der vom Ausgang 12:2 gesteuerte Treiber 48, der den PMOS-Transistor 42 steuert, an dessen Steueranschluss 49 entweder ein ausschaltendes Potential VCP vom Ausgang 12.1 oder ein einschaltendes Potential VCP - Δ vom Ausgang 12.3. Dabei ist VCP zum Beispiel um 10 V positiver als VSH und VCP - Δ ist um bspw. 5 V negativer als VCP.

Über den Transistor 42 wird der erste Leistungstransistor 16 eingeschaltet und über den Transistor 40 wird der erste Leistungstransistor 16 durch einen Kurzschluss seines Source-Anschlusses 50 und seines Gate-Anschlusses 52 ausgeschaltet. Am ersten Anschluss 50 (Source) des Transistors 40 liegt die Spannung VSH und am zweiten Anschluss 52 (Drain) liegt die Spannung VCP, die den Wert von VCH übersteigt. Der Unterschied zwischen VSH und VCP kann bspw. bis zu 20 V betragen, so dass der Transistor 40 zwischen seinem ersten und seinem zweiten Anschluss, also zwischen Source 50 und Drain 52, entsprechend bis zu 20 V sperren können muss. Da VSH bei eingeschaltetem ersten Leistungstransistor 16 dem Leistungs-Versorgungspotential vom Anschluss 20 entspricht, das bspw. einen Wert von 50 - 60 V besitzt, muss der Transistor 40 mit den angegebenen Werten zwischen Drain 52 und Substrat entsprechend bis zu 80 V sperren können.

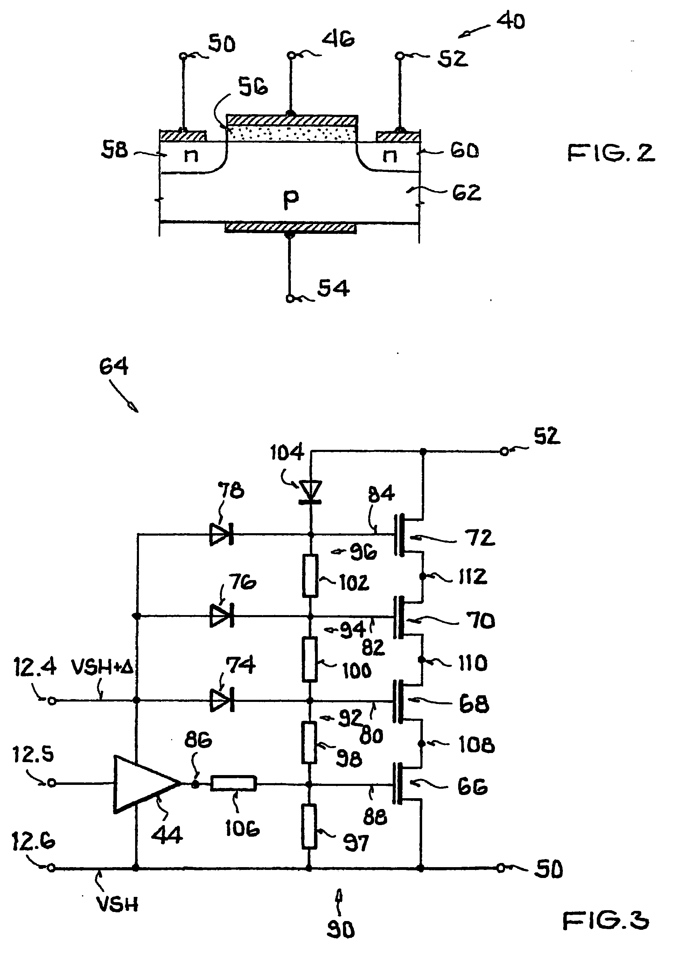

Zur Verdeutlichung dieser Anforderungen an die Spannungsfestigkeit zeigt Figur 2 schematisch einen Querschnitt durch einen n-Kanal MOS-Fet 40. Der MOS-Fet 40 weist einen Substratanschluss 54, einen Source-Anschluss 50, einen Drain-Anschluss 52 und einen Gate-Anschluss 46 über einem Gate-Oxid 56 auf. Im gezeigten Beispiel bildet sich bei hinreichend positivem Gate-Potential ein n-leitender Kanal zwischen n-dotiertem Sourcegebiet 58 und Drain-Gebiet 60 in einem p-leitenden Substrat. Wie in Zusammenhang mit Figur 1 beschrieben wurde, muss der Transistor 40 unter den als Beispiel genannten Umständen eine Spannung von 20 V zwischen Drain und Source sowie eine Spannung von ca. 80 V zwischen Drain und Substrat sperren können.

Wie eingangs aufgezeigt wurde, kommt es bei der Schaltungsentwicklung hin und wieder vor, dass sich die Anforderungen an die Spannungsfestigkeit mit vorhandenen Bauteilen schlicht und einfach nicht erfüllen lassen. Unter den in Verbindung mit Fig. 1 als Beispiel angegebenen Randbedingungen ist zum Beispiel ein n-Kanaltransistor 40 erforderlich, der zum Substrat 80 V sperren kann und dessen maximale Drain-Source-Spannung größer als 20 V sein muss.

Im Folgenden wird gezeigt, wie sich diese Anforderungen mit anderen Transistoren erfüllen lassen, wenn ein solcher Einzeltransistor nicht zur Verfügung steht.

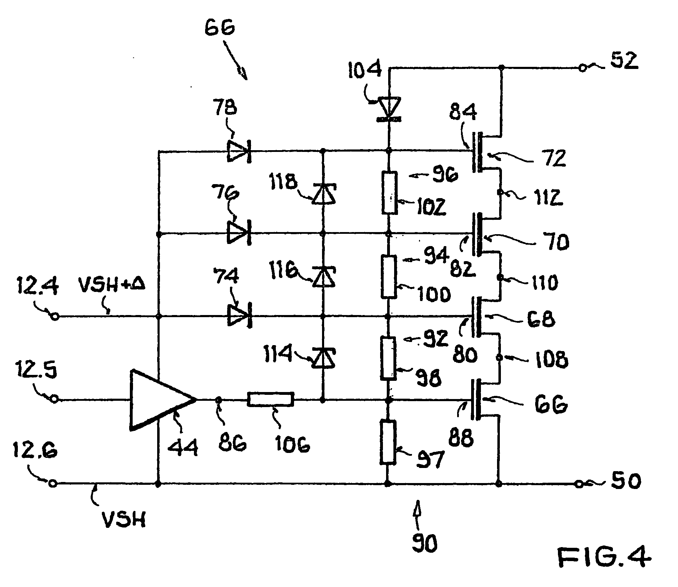

Figur 3 zeigt ein Ausführungsbeispiel einer erfindungsgemäßen Integrierten Schaltung 64, die den Einzeltransistor 40 aus Fig. 1 ersetzen kann, weil sie die geforderten Spannungsfestigkeiten zwischen erstem Anschluss 50 und zweitem Anschluss 52 sowie erstem oder zweitem Anschluss 50, 52 und dem Substrat 62 besitzt.

Die Integrierte Schaltung 64 weist einen ersten Transistor 66 und n = 3 weitere Transistoren 68, 70 und 72 auf, deren Leitfähigkeitsstrecken in Reihe zwischen dem ersten Anschluss 50 und dem zweiten Anschluss 54 der Integrierten Schaltung 64 liegen. Die Zahl n der weiteren Transistoren ist nicht auf das gezeigte Beispiel von drei weiteren Transistoren 68, 70 und 72 festgelegt, sondern kann jeder ganzen Zahl entsprechen, die größer oder gleich 1 ist. Weiter weist die Integrierte Schaltung 64 n Dioden 74, 76 und 78 auf, die jeweils zwischen einem Steueranschluss 80, 82, 84 der n Transistoren 68, 70, 72 und einem Treiber-Versorgungspotential VSH + Δ liegen. Das Treiber-Versorgungspotential entspricht dem mit einem additiven Offset Δ verknüpften Potential VSH am ersten Anschluss 50 aus Figur 1, wie es in Fig. 1 vom Anschluss 12.4 der Steuerlogik 12 bereitgestellt wird. Ein Steueranschluss 86 der Integrierten Schaltung 74 übergibt entweder das Treiber-Versorgungspotential VSH + Δ oder aber das Potential VSH am ersten Anschluss 50 an einen Steueranschluss 88 des ersten Transistors 66. Weiter weist die Integrierte Schaltung 64 einen Spannungsteiler 90 auf, der parallel zu den Leitfähigkeitsstrecken der Transistoren 66, 68, 70 und 72 zwischen dem ersten Anschluss 50 und dem zweiten Anschluss 52 liegt und der Steueranschlüsse 80, 82, 84, 88 der weiteren Transistoren 68, 70, 72 und des ersten Transistors 66 miteinander und mit dem ersten Anschluss 50 sowie dem zweiten Anschluss 52 verbindet. Dabei sind jeweils zwei Steueranschlüsse 80, 82, 84, 88 der Transistoren 68, 70, 72, 66 über einen zwischen ihnen liegenden Teilabschnitt 92, 94, 96 miteinander verbunden. Jeder Teilabschnitt 92, 94, 96 weist z. B. einen ohmschen Widerstand 98, 100, 102 auf. Ein Widerstand 97 als Teil des Spannungsteilers 90 sorgt für eine Verbindung zum ersten Anschluss 50.

Der Spannungsteiler 90 verteilt die Spannung zwischen dem ersten Anschluss und dem zweiten Anschluss der Integrierten Schaltung gleichmäßig auf die n Transistoren 66, 68, 70, 72. Als erwünschte Folge wird die Spannung über der Leitfähigkeitsstrecke jedes einzelnen Transistors 66, 68, 70, 72 im ausgeschalteten Zustand der Schaltung 64 nicht größer als ein zulässiger Maximalwert.

Optional weist der Spannungsteiler 90 noch eine Diode 104 auf, die zwischen dem zweiten Anschluss 54 und dem Steueranschluss 84 des Transistors 72 liegt, dessen Leitfähigkeitsstrecke ebenfalls an dem zweiten Anschluss 52 liegt.

Durch die richtungsabhängige Sperrwirkung dieser Diode 104 lässt sich am Steueranschluss 84 dieses Transistors 72 eine höhere Spannung einstellen als am zweiten Anschluss 52 der Integrierten Schaltung 64. Dadurch lässt sich der Transistor 72 unabhängig vom Potential am zweiten Anschluss 52 der Integrierten Schaltung 64 einschalten.

Ferner weist die Schaltung 64 optional einen Entkoppelwiderstand 106 zwischen dem Steueranschluss 86 und dem Steueranschluss 88 des ersten Transistors auf. Im Fall einer Überspannung sorgt dieser Widerstand 106 für eine Potentialdifferenz zwischen dem Steueranschluss 88 des ersten Transistors 66 und dem Steueranschluss 86 der Integrierten Schaltung 64. Dadurch wird gewährleistet, dass auch der erste Transistor 66 im Fall einer Überspannung öffnend angesteuert wird. Durch das öffnende Ansteuern der Transistoren 66, 68, 70, 72 wird eine durchgehende Leitfähigkeitsstrecke zwischen dem ersten Anschluss 50 und dem zweiten Anschluss 52 der Integrierten Schaltung 64 bereitgestellt, über die ein Abbau der Überspannung erfolgen kann.

Die Schaltung 64 lässt sich in Abhängigkeit vom Potential am Steuereingang 86 zwischen zwei Zuständen umschalten. In einem ersten Zustand liefert der Treiber 44 das Potential VSH an den Steueranschluss 86. Am Steueranschluss 88 des ersten Transistors 66 stellt sich dann das gleiche Potential VSH ein, wie am ersten Anschluss 50 und damit am Source-Anschluss des ersten Transistors 66. Dadurch bildet sich im ersten Transistor 66 kein leitfähiger Kanal aus, so dass die Leitfähigkeitsstrecke des ersten Transistors 66 und damit auch die Leitfähigkeitsstrecke über die übrigen Transistoren 68, 70, 72 unterbrochen ist. Bei einem Einsatz der Integrierten Schaltung 64 anstelle des Transistors 40 in Figur 1 stellt sich bei unterbrochener Leitfähigkeitsstrecke am Source-Anschluss 50 das Leistungs-Versorgungspotential vom Anschluss 20 und am Drain-Anschluss 52 ein um bspw. 16 V höheres Potential VCP ein. Diese Potentialdifferenz von 16 V wird durch den Spannungsteiler 90 gleichmäßig auf die Steueranschlüsse 88, 80, 82 und 84 verteilt, so dass sich am Steueranschluss 88 ein Potential von 0 V, am Steueranschluss 80 ein Potential von ca. 5 V, am Steueranschluss 82 ein Potential von ca. 10 V und am Steueranschluss 84 ein Potential von ca. 15 V einstellt. Etwa 1 V fällt über der Diode 104 ab.

An den Source-Anschlüssen 108, 110, 112 stellen sich dann ähnliche Potentiale ein, so dass am Source-Anschluss 100 größenordnungsmäßig 5 V, am Source-Anschluss 110 etwa 10 V und am Source-Anschluss etwa 15 V anliegen. D. h., die zwischen den Anschlüssen 50 und 52 der Integrierten Schaltung 64 auftretende Potentialdifferenz von z. B. 16 V xxx 66, 68, 70, 72 verteilt. Jeder einzelne der Transistoren 66, 68, 70, 72 muss daher nur einen Bruchteil der Spannungsfestigkeit aufweisen, die ein einzelner Transistor 40 aufweisen müsste, um in der Schaltungsanordnung nach Figur 1 eingesetzt werden zu können. Für die Anforderungen an die Spannungsfestigkeit zwischen Drain und Substrat ergeben sich keine Unterschiede zwischen den Transistoren 66, 68, 70, 72 auf der einen Seite und einem Einzeltransistor 40 auf der anderen Seite.

Die Dioden 74, 76, 78 verhindern, dass sich unterschiedliche Potentiale an den Steueranschlüssen 80, 82 und 84 gegenseitig beeinflussen.

Um eine leitende Verbindung zwischen den Anschlüssen 50 und 52 der Integrierten Schaltung 64 einzuschalten, wird der Ausgang des Treibers 44 über den Anschluss 12.5 vom Potential VSH auf das Potential VSH + Δ umgeschaltet, so dass der Transistor 88 (bei einer Ausführung als NMOS) leitet. Als Folge sinkt das Potential am Anschluss 108, so dass der Steueranschluss des Transistors 68 positiv gegen seinen Source-Anschluss 108 wird. Das positive Potential am Steueranschluss 88 schaltet den Transistor 68 ein. Analog werden auch die Transistoren 70 und 72 eingeschaltet, so dass sich eine durchgehende leitende Verbindung zwischen den Anschlüssen 50 und 52 über die Transistoren 66, 68, 70 und 72 ergibt.

Fig. 4 zeigt eine Integrierte Schaltung 66, die sich von der Integrierten Schaltung 64 aus Fig. 3 durch eine zusätzliche Reihenschaltung aus n = 3 Zenerdioden 114, 116, 118 unterscheidet. Jede der Zenerdioden 114, 116, 118 liegt parallel zu einem der Teilabschnitte 92, 94, 96 des Spannungsteilers 90 liegt, mit denen Steueranschlüsse 88, 80, 82, 84 der Transistoren 66, 68, 70, 72 miteinander verbunden sind.

Im Fall einer Überspannung, die bspw. durch eine elektrostatische Entladung zwischen dem ersten Anschluss 50 und dem zweiten Anschluss 52 der Integrierten Schaltung 66 auftreten kann, öffnen diese Zenerdioden 114, 116, 118 einen Strompfad, der die Teilabschnitte 92, 94, 96 des Spannungsteilers 90 überbrückt, so dass sich an den Steueranschlüssen 88, 80, 82, 84 der Transistoren 66, 68, 70, 72 gleiche, öffnende Potentiale einstellen.

## Patentansprüche

1. Integrierte Schaltung (64) mit einem ersten Anschluss (50), einem zweiten Anschluss (52), einem Substrat (62) und einem Steueranschluss (86), wobei
der Steueranschluss (86) eine Leitfähigkeit der Integrierten Schaltung (64) zwischen dem ersten Anschluss (50) und dem zweiten Anschluss (52) steuert,
**gekennzeichnet durch**
einen ersten Transistor (66) und n weitere Transistoren (68, 70, 72) mit in Reihe zwischen den ersten Anschluss (50) und den zweiten Anschluss (52) geschalteten Leitfähigkeitsstrecken, wobei n eine ganze Zahl größer oder gleich 1 ist,
n Dioden (74, 76, 78), wobei jede der n Dioden (74, 76, 78) zwischen einem Steueranschluss (80, 82, 84) der n Transistoren (68, 70, 72) und einem Treiber-Versorgungspotential (VSH + Δ) liegt, das dem mit einem additiven Offset (Δ) verknüpften Potential (VSH) am ersten Anschluss (50) entspricht, und wobei der Steueranschluss (86) der Integrierten Schaltung (64) entweder das Treiber-Versorgungspotential (VSH + Δ) oder das Potential (VSH) am ersten Anschluss (50) an einen Steueranschluss (88) des ersten Transistors (66) übergibt, und
einen Spannungsteiler (90), der parallel zu den Leitfähigkeitsstrecken zwischen dem ersten Anschluss (50) und dem zweiten Anschluss (52) liegt und der Steueranschlüsse (88, 80, 82, 84) der Transistoren (66, 68, 70, 72) miteinander und mit dem ersten Anschluss (50) sowie dem zweiten Anschluss (52) verbindet, wobei jeweils zwei Steueranschlüsse der Transistoren (66, 68, 70, 72) über einen zwischen ihnen liegenden Teilabschnitt (92, 94, 96) des Spannungsteilers (90) miteinander verbunden sind.

2. Integrierte Schaltung (64) nach Anspruch 1, **dadurch gekennzeichnet, dass** der Spannungsteiler (90) eine Diode (104) aufweist, die zwischen dem zweiten Anschluss (52) und dem Steueranschluss (84) des Transistors (72) liegt, dessen Leitfähigkeitsstrecke ebenfalls an dem zweiten Anschluss (52) liegt.

3. Integrierte Schaltung (64) nach wenigstens einem der vorhergehenden Ansprüche, **gekennzeichnet durch** eine Reihenschaltung aus n Zenerdioden (114, 116, 118), von denen jede parallel zu einem der Teilabschnitte (92, 94, 96) des Spannungsteilers (90) liegt, mit denen Steueranschlüsse (88, 80, 82, 84) der Transistoren miteinander verbunden sind.

4. Integrierte Schaltung (64) nach Anspruch 1 oder 2, **gekennzeichnet durch** einen Widerstand zwischen dem Steueranschluss (86) der Integrierten Schaltung (64) und dem Steueranschluss (88) des ersten Transistors (66).

5. Integrierte Schaltung (64) nach wenigstens einem der vorhergehenden Ansprüche, **dadurch gekennzeichnet, dass** die Transistoren als MOS-Feldeffekttransistoren realisiert sind.

6. Integrierte Schaltung (64) nach wenigstens einem der vorhergehenden Ansprüche, **gekennzeichnet durch** eine Realisierung in CMOS-Technik.

7. Integrierte Schaltung (64) nach wenigstens einem der vorhergehenden Ansprüche, **gekennzeichnet durch** eine Teilschaltung (26), die ein variables Potential an den ersten Anschluss (50) übergibt.

8. Integrierte Schaltung (64) nach wenigstens einem der vorhergehenden Ansprüche, **gekennzeichnet durch** einen ersten Leistungstransistor (16), dessen Leitfähigkeitsstrecke zwischen dem ersten Anschluss (50) und einem Leistungs-Versorgungspotential-Anschluss (20) liegt und der **durch** den zweiten Anschluss (52) gesteuert wird.

9. Integrierte Schaltung (64) nach wenigstens einem der vorhergehenden Ansprüche, **gekennzeichnet durch** einen weiteren Leistungstransistor (18), dessen Leitfähigkeitsstrecke mit der Leitfähigkeitsstrecke des ersten Leitfähigkeitstransistors (16) in Reihe zwischen dem Leistungsversorgungspotential-Anschluss (30) und einem Bezugspotential-Anschluss (22) der Schaltung (64) liegt.
